(19) Europäisches Patentamt
European Patent Office
Office européen des brevets

(11) Publication number: **0 027 180**
**B1**

(12) **EUROPEAN PATENT SPECIFICATION**

(45) Date of publication of patent specification: **01.02.84**

(51) Int. Cl.³: **G 03 C 1/72,** G 03 C 5/16

(21) Application number: **80105502.1**

(22) Date of filing: **15.09.80**

(54) **Photo, E-beam, and X-ray sensitive negative resists based on donor polymer-doped halocarbon acceptor transfer complexes and method for producing negative resist images.**

(30) Priority: **10.10.79 US 83496
10.10.79 US 83495
10.10.79 US 83491**

(43) Date of publication of application:
**22.04.81 Bulletin 81/16**

(45) Publication of the grant of the patent:
**01.02.84 Bulletin 84/5**

(84) Designated Contracting States:
**BE CH DE FR GB IT LI NL SE**

(56) References cited:

**None**

(73) Proprietor: **International Business Machines Corporation
Old Orchard Road
Armonk, N.Y. 10504 (US)**

(72) Inventor: **Aviram, Ari
265 Prince Court
Yorktown Heights New York 10598 (US)**
Inventor: **Hofer, Donald Clifford
Hopewell Junction RD. 2 Box 113
New York 12533 (US)**
Inventor: **Kaufman, Frank Benjamin
762 Kitchawan Road
Ossining New York (US)**
Inventor: **Kramer, Steven Robert
60A Moseman Ave. RD. 2
Katonah New York 10536 (US)**
Inventor: **Hatzakis, Michael
12 Hunting Ridge Place
Chappaqua New York 10514 (US)**
Inventor: **Jones, Fletcher
121 South Highland Ave. Apt. 5H
Ossining New York 10562 (US)**
Inventor: **Shaw, Jane Margaret
49 Old Sib Road
Ridgefield Connecticut 06877 (US)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**EP 0 027 180 B1**

(74) Representative: **Kreidler, Eva-Maria, Dr. rer. nat.**
**Schönaicher Strasse 220**
**D-7030 Böblingen (DE)**

# Photo, E-beam and X-ray sensitive negative resists based on donor polymer-doped halocarbon acceptor transfer complexes and method for producing negative resist images

*Field of the Invention*

The invention lies in the field of photo, E-beam and X-ray sensitive negative resists based on donor polymer-doped halocarbon acceptor transfer complexes and also comprises a method for producing negative resist images.

*Prior Art*

The prior art is replete with radiation sensitive materials as resists and with their use in pattern formation in the fabrication of microelectronic devices. In the prior art, pattern formation in these materials is dependent upon differential solubility between irradiated and unirradiated regions. These solubility changes are produced by either bondbreaking, (chain scission) or bond formation (chain crosslinking) in polymeric systems. This occurs in the presence of actinic radiation, E-beam radiation or X-ray radiation.

Several prior art resists have included in them halogen containing organic compounds or halocarbons. These halocarbons, which are generally present to enhance the sensitivity of the resist, are discussed and reviewed in U.S. Patents 3 752 669; 3 769 023; 3 820 993; 3 895 954; 3 988 152 and 3 916 036. The resists disclosed in the above references are sensitive to either actinic or electron beam radiation. The prime need for the halocarbon in these resists are for the generation of free radicals to initiate polymerization.

More recently there has been developed a new class of E-beam resist materials based on donor-charge transfer salts see EP—A—0 023 988. These materials are different and distinct from the present composition in that they are crystalline salts that are coated onto a substrate by evaporation or sublimation, wherein the present compositions are amorphous polymeric materials which are cast from a solution. The present resist compositions are two component systems in which differential solubility is generated via salt formation as opposed to the one component system of the above-mentioned application in which a neutral substance is produced. Additionally, the materials used in the present invention are insulating while the aforementioned are conductive.

The prior art materials have several drawbacks among which is the difficulty of obtaining sharp images of high resolution, particularly in negative resists. This is due to the swelling of the polymeric material during solvent development.

Object of the present invention are photo-, E-beam and X-ray resist materials which do not show these drawbacks.

The object of the invention is achieved by providing photo-, E-beam, and X-ray sensitive negative resists comprising active polymers consisting of a polymer backbone and an active molecule bonded thereto, said molecule

a) being capable of electron oxidation to a cation;
b) having an oxidation potential of from about 0.1 V to about 1 V measured against a standard calomel electrode;
c) being capable of photoionizing in the presence of a halogen containing organic compound; and
d) having a functional group which when reacted with a polymer support will be bonded thereto;

and said active polymers being doped with a halogen containing organic compound.

The resist materials can be broadly classified as donor polymer-doped halocarbon charge transfer complexes.

The invention also comprises a method for producing negative resist images.

## DESCRIPTION OF THE INVENTION

The present invention teaches novel photo, E-beam, and X-ray resist materials which can be used to provide a negative resist image. Principally, the materials are comprised of electroactive polymers and a halocarbon. The electroactive polymer consists of a polymer backbone and a electroactive molecule as hereinbefore defined bonded thereto. Several of the electroactive polymers of the type anticipated for use in this invention are described in U.S. Patent 4 142 783 and in the IBM Technical Disclosure Bulletin, Vol. 20, No. 7, December 1977, pp, 2862—2864.

The polymeric backbone can be selected from several known homopolymer and copolymer compositions having skeletal functional groups or side chains having functional groups capable of reacting with the functional groups of donor molecules. Polymers which can be used include a copolymer of polystyrene and chloromethylated styrene, e.g.,

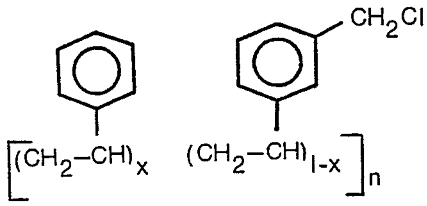

where the value of X is varied (0<x<1), so that the number of donor molecules per chain and their distance apart can be varied. The desired lithographic properties are thus varied as a function of X;

Typically, other polymer backbones can be selected from the following:

polyglutamic acid

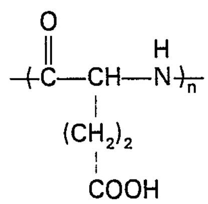

polyvinyl chloride

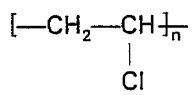

polyepichlorohydrin

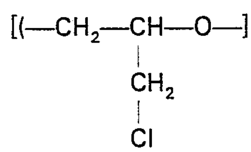

poly($\alpha$halo phosphazenes)

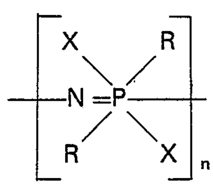

poly(acrylic chloride)

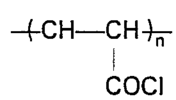

and the like.

The donor molecules that can be used in this invention are those which can be characterized as having the following specific molecular properties:

(a) Those that are capable of electron oxidation to a cation.

(b) Have an oxidation potential of from about 0.1 V to about 1 V measured against a standard calomel electrode;

(c) those that photoionize in the presence of a halocarbon; and

(d) which have a functional group which when reacted with a polymer support will be bonded thereto. Functional groups contemplated by the present invention include hydroxyl, phenoxy, carboxyl, amino groups and the like.

A wide variety of $\pi$ donor molecules are expected to be active in polymeric form as negative resist materials.

This invention may be effected by using donors of the empirical formula $C_6H_4X_4R_4$ and having the structural formula

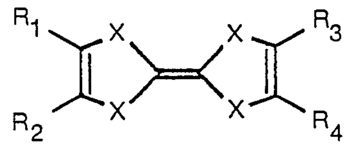

where X=O, S, Se, and Te or any combination thereof. The R groups may be of any organic substituent including alkyls, such as methyl and ethyl, phenyls, substituted phenyls, $—SCH_3$, $—CO_2Me$, halogen, fused cyclics in which the substituent effectively connects R1 with R2 and R3 with R4, e.g. Some specific fulvalene compositions include tetrathiafulvalene (TTF), its derivatives and Se analogs (TSeF) and its derivatives, for example, tetrathiafulvalene-carboxylic acid ($TTFCO_2H$), tetraselenafulvalene-carboxylicacid (hydroxymethyl)-tetrathiafulvalene ($TTFCH_2OH$), hydroxymethyltetraselenafulvalene ($TSeFCH_2OH$), (p-hydroxyphenyl)-tetrathiafulvalene ($TTFC_6H_4OH$), (p-hydroxyphenyl)-tetraselenafulvalene ($TSeFC_6H_4OH$), (p-aminophenyl)-tetrathiafulvalene ($TTFC_6H_4NH_2$), (p-carboxyphenyl)tetrathiafulvalene ($TTFC_6H_4CO_2H$), phenoxy-(TTF):

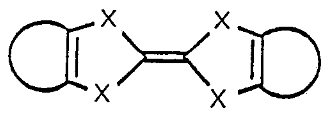

The following fused rings, such as cyclopentene, cyclohexene, benzene, furan, thiophene, dihydrofuran and dihydrothiophene, and derivatives thereof can be used. In addition, tetrathiatetracene compounds, e.g.

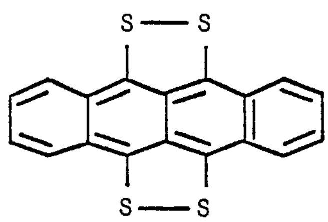

and their derivatives are also suitable for the purpose of this invention. In general, organic $\pi$-electron donors having low ionization potentials ($<7.5$ eV)[2] can be used.

Additionally, the following compositions are contemplated by this invention;

Amines

$R—NH_2$, R=Alkyl, Aryl

Pyrazolines

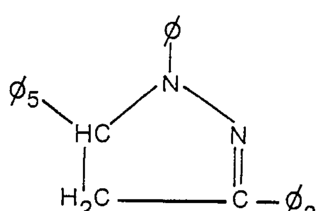

Pyrazolines of particular importance include:

1,3-di-(p-methoxyphenyl)-5-(p-hydroxyphenyl)-$\Delta^2$-pyrazoline,
1,5-di-(p-methoxyphenyl)-3-(p-hydroxyphenyl)-$\Delta^2$-pyrazoline,
3,5-di-(p-methoxyphenyl)-1-(p-hydroxyphenyl)-$\Delta^2$-pyrazoline,
1,3-di-(p-methoxyphenyl)-5-(p-carboxyphenyl)-$\Delta^2$-pyrazoline,
1,5-di-(p-methoxyphenyl)-3-(p-carboxyphenyl)-$\Delta^2$-pyrazoline,
3,5-di-(p-methoxyphenyl)-1-(p-carboxyphenyl)-$\Delta^2$-pyrazoline,
1,3-di-(p-methoxyphenyl)-5-(p-aminophenyl)-$\Delta^2$-pyrazoline,
1,5-di(phenyl)-3-(p-aminophenyl)-$\Delta^2$-pyrazoline,
1-(p-hydroxyphenyl)-3-(p-methoxystyryl)-5-(p-methoxyphenyl)-$\Delta^2$-pyrazoline,
1-(p-hydroxyphenyl)-3-(p-diethylaminostyryl)-5-(p-diethylaminophenyl)-$\Delta^2$-pyrazoline.

Ferrocene

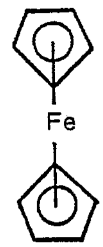

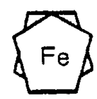

$[(\eta^5—C_5H_5)Fe(CO)]_4$

Phenothiazine

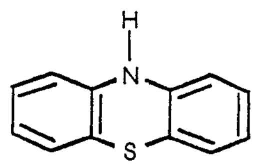

The acceptor molecules that can be used in this invention are those which can be characterized as having the following specific molecular properties:

(a) Contains one or more halogen atoms.

(b) Has high electron affinity to accept electron from donor species (0—2 eV).

(c) Forms anionic species.

Typical halocarbon acceptors which can be used are selected from $CCl_4$, $CBR_4$, $Cl_4$, $C_2Cl_6$, $C_2Cl_2Br_4$, $C_3Br_4H_4$, $C_2Br_2Cl_4$, $C_2H_2Cl_4$, $C_2Br_6$, $C_3Cl_8$, $CHBr_3$, $CHCl_3$, $CH_2Cl_2$ and the like.

The halocarbon agent may be present in amounts ranging from 0.01 to 10 times the concentration of the donor moiety.

There are two basic kinds of synthetic procedures for covalently attaching the donor molecules to the polymer resin. In equation (1),

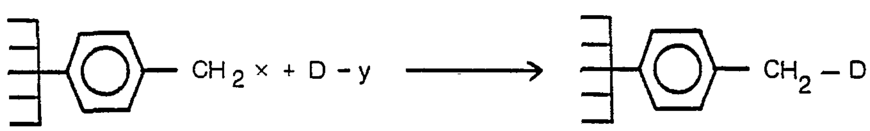

where

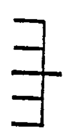

is a polymer, x is a halogen, D is a donor molecule, and y is a functional group capable of coupling D to the benzene ring. In this procedure, preformed and appropriately functionalized donor molecules (D—Y) are reacted in single-step coupling procedures with the polymer resin. In this approach, the groups -x and -y are chosen so as to lead to coupled products. Bonding to the polymer matrix is accomplished in one step. In an alternate method, (i.e. reactions 2 and 3), the desired electroactive molecule is synthesized from polymer precursors directly on the resin. Thus, functionalized electroactive species are not required; however, multiple polymer reactions become necessary.

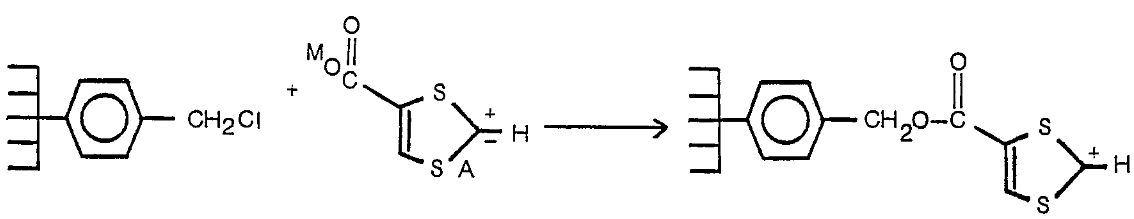

(2)

(3)

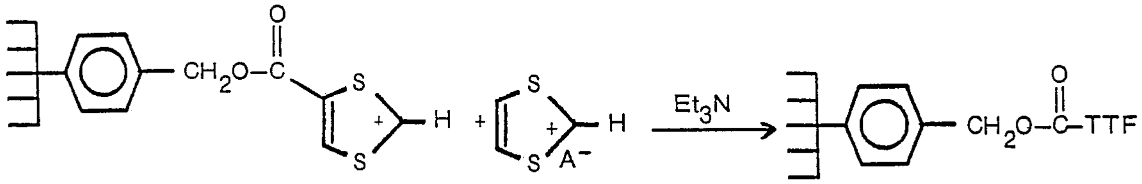


The specific steps of the synthesis of the contemplated compositions can be found in U.S. Patent 4 142 783.

The solvents which can be used for film coating are toluene, chloroform, methylene chloride, cyclopentanone, tetrahydrofuran, methyl-ethyl-ketone etc.

In the present invention resist compositions are exposed to U.V. radiation, E-beam radiation or X-ray radiation.

U.V. exposures were performed using a 200 watt Hg lamp in conjunction with a contact printer. The lamp output was 40 mW/cm$^2$ in the plane of the wafer and a dichroic mirror was used during exposure to absorb infrared radiation. The lamp produces broad band U.V. radiation, i.e., in the range of 300 nm to 500 nm. The mask used was E-beam generated using a chrome substrate. Exposure times were typically 10 seconds to 120 seconds.

E-beam exposure were performed in a vacuum of about $1.33 \cdot 10^{-3}$bar on a scanning E-beam system at 20 KV beam voltage. The charge density is in the range of about $1 \times 10^{-6}$ C/cm$^2$ to about $50 \times 10^6$ C/cm$^2$.

X-ray exposure were performed in $1.33 \cdot 10^{-3}$bar vacuum, using a vacuum generator 1 KeV electron gun, with 7 KV gun voltage and 40 mA gun current. The X-rays having an energy of about 1.34 KeV are generated with an Al target (0.83 nm) and X-ray spot of 1—2 mm size. A gold (600 nm) mask on a polyimide substrate is coated with 50 nm of Al to prevent optical exposure of the resist. The mask-wafer separation used is 4 $\mu$m, and the copy is obtained at a gun-wafer separation of 18 cm. Under these conditions the copy time for a 100 mj/cm$^2$ dose is about three hours. X-ray exposures involve doses of 25—100 mj/cm$^2$.

More specifically, this invention concerns new compositions of matter which function in a novel resist process when irradiated by actinic radiation, E-beam radiation or X-ray radiation. For example, films of a polymeric TTF material can be spin cast from a solution containing a halocarbon acceptor, such as $CBr_4$. Under these conditions the resulting polymer film contains $CBr_4$ and becomes sensitive to radiation. When actinic radiation, E-beam radiation or X-ray radiation is used to irradiate these films through appropriate masks, only the unexposed areas can be removed from the underlying substrate by washing with a non-polar solvent. This negative resist process is a novel one and unrelated to those suggested earlier for polymers whose solubility decreases upon exposure to radiation because of radiation induced crosslinking reactions.

It is suggested that these resists operate by means of the radiation-induced formation of a salt, according to reaction 1.

$$\text{Poly(TTF)} + CBr_4 \rightarrow \text{poly}(TTF^+)\ (Br^-) \qquad (1)$$

The neutral polymer is soluble in non-polar solvents while the salt produced is insoluble. This reaction is known to occur with monomeric TTF in solution, U.S. Patent 4 036 648, where the halide salt produced is insoluble in non-polar solvents. This new mechanism for lithographic action has been established in the following ways.

Using visible-near IR spectrophotometry, the TTF ions postulated in the above reaction have been detected. By irradiating poly(TTF) doped halocarbon films that were spun onto transparent substrates it has been observed that the films' spectrum changes during irradiation to give new absorption at 600 nm and at 800 nm, previously identified as characteristic of TTF$^+$ ion and aggregates thereof. (see the publication to J. B. Torrance et al entitled "Optical Properties of the Radical Cation Tetrathiafulvalenium in its Mixed-Valence and Monovalence Halide Salts", Phys. Rev. B, *19* 730 (1979). Additional predictions of the suggested mechanism have also been observed. For instance, it would be expected that polymer films containing no halocarbon present would be much less sensitive to incident radiation. Confirming this point it has been observed that irradiation of the undoped TTF polymer films gave no lithographic images when subjected to the same incident radiation as in the case of doped films.

Another facet of this mechanism is that reversing of the charge transfer in Reaction 1, see reaction 2 below, could be expected to lead to a change in the solubility properties, whereby the irradiation

$$\text{poly}(TTF^+)\ (X^-) \rightarrow \text{poly TTF} \qquad (2)$$

process would be nullified and removal of the polymer (now in its neutral state) could take place. This effect has been demonstrated in the following way. An exposed film was found to be insoluble in the

organic solvent dimethylformamide (DMF). However, when the chemical reducing agent hydrazine is added to the DMF solution it was observed that the exposed polymer film was readily removed leaving a clean Si substrate. In this process hydrazine reduces the oxidized $TTF^+$ back to its neutral form TTF and the neutral polymer, thus formed can be readily dissolved in the organic solvent.

The third ramification of the postulated mechanism is that other $\pi$-donor polymers should be lithographically active in the presence of halocarbon dopants. As alluded to previously, $\pi$-donor sensitivity to radiation with halocarbons present has been observed for a large number of donors in fluid solution. If the postulated mechanism is correct it would be expected that the same variety of donor halocarbon ionization found in solution would also be observed in the polymeric solid state. Similar lithographic differential solubility with donors such as pyrazoline, dimethylphenylenediamine, and ferrocene bound to polymeric backbones and prepared as halocarbon doped films, has in fact been observed.

A prime disadvantage of previous negative resist materials is the inherently low resolution of the patterns obtainable. As discussed earlier, negative resists typically operate by means of a radiation-induced crosslinking process. Although the crosslinked polymer that remains cannot be dissolved in a developer solvent, penetration of the solvent into the polymer causes swelling of the polymer chains since many of the development solvents are thermodynamically good solvents for the unexposed non-crosslinked polymer. The swelling process grossly distorts the lithographic pattern, and attempts to alleviate this problem by use of mixed solvents or thermal treatments have largely been unsuccessful.

For the present resist process, however, the lithographic patterns obtained showed no evidence for solvent induced distortions or loss of resolution. It is suggested that solvent penetration of the polymer followed by swelling is prevented in the system described herein, by the presence of ions which act to repel the non-polar solvent from the polymer matrix. Thus solvent cannot penetrate into the exposed polymer mass and cause swelling.

## Examples

The following examples are given solely for purposes of illustration. In the examples the following abbreviations are used:

DMF ≙ dimethyl-formamide;
DCC ≙ N,N'-dicyclohexylcarbodiimide
THF ≙ tetrahydrofuran;

### Example 1

Poly(vinylcarboxytetrathiafulvalene)

Poly(vinylbenzylchloride), prepared from the monomer vinylbenzylchloride, 0.275 g, and the cesium salt of tetrathiafulvalene carboxylic acid, 0.750 mg, is added to 75 ml of DMF and stirred at 75°C for 24 hours. The solution is concentrated and the resultant polymer is isolated by precipitation into a rapidly stirred $H_2O$ solution. Repeated precipitations from THF/$H_2O$ gave a dark brown solid. Anal. calc'd for

$C_{15.1}H_{11.6}S_{3.5}O_{1.7}Cl_{0.13}$, $[C_9H_9(C_7S_4H_3O_2)_{0.87}(Cl)_{0.13}]$

C=53.81, S=33.09, Cl=0.14. Found C, 53.74; S, 32.96; Cl, 0.23.

Polymer films are prepared by mixing 4.7 mg of the polymer with 1 mg of $C_2Br_2Cl_4$ which is added to 20 $\mu$l of cyclopentanone. The films are spin coated at 2500 RPM on a photoresist spinner. No baking is required in order to obtain good images. Solvents used as developers include tetrahydrofuran cyclopentantone, diglyme, methylene chloride, chloroform and mixtures thereof.

Several poly(TTF) films are prepared in this manner. To determine the sensitivity of this resist, some of these films are exposed to U.V. radiation from a 200 watt Hg lamp.

Some films were exposed to E-beams with doses from 2—40 x $10^{-6}$ C/cm². The films were developed in 1:1 THF: cyclopentanone and then the thickness of the remaining resist was determined with a surfanalyzer. From the resulting plot of normalized thickness remaining vs. dose rate, see Fig. 1, it can be seen that the sensitivity of the material for 50% thickness remaining is ~5 Coul/cm². From data on other resist materials (Table I, page, 19), it can be seen that the present material is one of the most sensitive resists known.

DETERMINATION OF RESOLUTION OF RESIST:

An E-beam exposed pattern was studied via scanning electron microscopy (see Fig. 2). These photographs show no evidence for the classical negative resist swelling behaviour. All of the patterns are extremely well-formed, with parallel, vertical walls and showing no signs of pattern distortion. From the indicated scale, it is estimated that the present resist has a resolution of better than 200 nm.

Some films were exposed to X-rays of energies ranging form 15—100 mj/cm². The films were developed in THF, and then the thickness of the remaining resist was determined with a surfanalyzer. From the resulting plot of normalized thickness remaining vs. dose rate, see Fig. 3, it can be seen that the sensitivity of the material for 50% thickness remaining is ~4 mj/cm². From data on other resist

materials (Table II, page 19), it can be seen that the present material is one of the most sensitive resists known.

DETERMINATION OF RESOLUTION OF RESIST:

An X-ray exposed pattern was studied via scanning electron microscopy (see Fig. 4). These photographs show no evidence for the classical negative resist swelling behaviour. All of the patterns are extremely well formed, with parallel, vertical walls and showing no signs of pattern distortion. From the indicated scale, it is estimated that the present resist has a resolution of better than 200 nm.

Example 2

Poly(vinylcarboxyferrocene)

Poly(vinylbenzylchloride), 150 mg, is reacted with 360 mg of the cesium salt of ferrocene carboxylic acid, (as prepared below) in 65 ml DMF solvent. The solution is heated to 75°C, and stirred for 24 hours. The volume of the solution is reduced and the polymer is precipitated into $H_2O$. Repeated precipitations ($THF/H_2O$) gave a light yellow solid.

Anal. calc'd for $C_9H_9(C_{7.5}H_{5.4}O_{1.4}Fe_{0.7})$ $(Cl_{0.3})$

C, 69.9; Fe, 13.4; Cl, 4. Found C, 67.62; Fe, 12.11; Cl, 4.61.

Cesium salt of carboxyferrocene. Monocarboxyferrocene, 230 mg, is dissolved in ethanol. To this solution is added 5 ml of $H_2O$ which contained 250 mg $CsHCO_3$. Using slight heating and high vacuum, the solution was taken to dryness to produce the desired salt.

About 5.2 mg of the so prepared polymer and about 1 mg of $C_2Br_2Cl_4$, the acceptor compound are added to 26 $\mu$l of THF solvent and films are spun at 2500 RPM on a photoresist spinner. The films are exposed to U.V. radiation, E-beam radiation or X-ray radiation in the range of 10—100 mj/cm², as in Example 1. Patterns obtained by exposure to u.v. radiation or X-rays are developed by one of the following solvents or mixtures thereof: toluene, chloroform, methylene chloride, cyclopentanone, THF. Patterns obtained by exposure to E-beams are developed in toluene:THF mixtures. No pre- or post exposure baking is required to obtain good images.

Example 3

Poly(vinylphenoxy-1,3-(p-methoxyphenyl)-5-(p-hydroxyphenyl)-$\Delta^2$-pyrazoline):

The potassium salt of the pyrazoline is prepared by adding 374 mg pyrazoline to 40 mg KH in dry THF. After stirring for 30 minutes, 152 mg of polyvinylbenzylchloride is added to this solution. After refluxing for 4 days, the solvent volume was reduced and the polymer isolated following multiple reprecipitations from 50:50 $NeOH/H_2O$. About 4.6 mg of the polymer and 1 mg of the $C_2Br_2Cl_4$ acceptor are added to 32 $\mu$l of THF. Films were spun at 2500 RPM on a photoresist spinner. After U.V. exposures, E-beam exposures or X-ray exposures, as in the above examples, good images are obtained by developing in toluene:THF mixtures. No pre- or post exposure baking was required to obtain good images.

Example 4

Poly[p-N,N-dimethylamino)-N-$\gamma$-D-glutamanilide]

Poly(D-glutamic acid) (Miles-Yeda Ltd. mol. wt. 12400), 0.5 g, is dissolved in 50 ml of dry DMF and 2 g of freshly distilled N,N-dimethyl-p-phenylenediamine is then added. The solution is cooled to 0°C and 1 g of DCC is added with stirring. Stirring is continued at 0°C for 1 h and at room temperature for an additional 24 h. One milliliter of dry methanol is added and stirring is continued for an additional h. The precipitate is filtered off and the filtrate is evaporated to dryness at 35°C bath temperature (0.01 mm). The residue is dissolved in THF and filtered in a drybox under nitrogen. Diethyl ether is added to the solution and the precipitate is filtered and collected under nitrogen. The collected solid is further purified by precipitation from THF with diethyl ether.

Anal. Calcd. for $(C_{13}H_{17}N_3O_2)_n$

C, 62.90; H, 6.85; N, 16.93. Found: C, 62.69; H, 7.64; N, 14.54.

About 15 mg of the above prepared polymer (5.0 mg) and the $C_2Br_2Cl_4$ acceptor, 1 mg, are added to 29 $\mu$l THF and films are spun (2500 RPM) on a photoresist spinner. After exposure to U.V. E-beam or X-rays as in the above examples, good images are obtained by use of methyl-ethyl-ketone developer solvent. No baking was required.

Example 5

Polyphenoxytetrathiafulvalene

About 15 mg of polyphenoxytetrathiafulvalene and 1.0 mg of $C_2Br_2Cl_4$ are added to 29 $\mu$l THF and films are spun (2500 RPM) on a photoresist spinner. After exposure to U.V., E-beam or X-rays, as in the above examples, good images are obtained by use of methyl-ethyl-ketone developer solvent. No baking was required.

TABLE I

| Resist | E-Beam (20 KV) Dose 1 $\mu$Coul/cm$^2$ | Resolution |
|---|---|---|
| PMMA* | 80 | 10 nm |
| FBM* | | <1 $\mu$m |
| PBS* | 2 | <.5 $\mu$m |
| P(GMA-co-EA)* | .3 | 1 $\mu$m |
| PS* | 40 | 200 nm |
| PCA* | 8 | 1 $\mu$m |

*PMMA — Poly(methyl methacrylate)
FBM — Poly(fluoro methacrylate)
PBS — Poly(butyl sulfone)
P(GMA-co-EA) — Poly(glycidyl methacrylate ethyl acrylate copolymer)
PS — Polystyrene
PCA — Polychloroacrylate

TABLE II

$Al_{K\alpha}$ X-Ray

| | Resist | Sensitivity (mj/cm$^2$) | Resolution |
|---|---|---|---|
| | PMMA** | 1000 | .02 $\mu$ |
| POSITIVE | PBS** | 80 | <1 $\mu$ |
| RESISTS | FBM** | 30 | <1 $\mu$ |
| | Methyl-acrylate | 20 | >1 $\mu$* |
| NEGATIVE | PGMA-EA** | 5 | >1 $\mu$* |
| RESISTS | Polystyrene-TTF** | 40 | ~0.2 $\mu$ |

*Materials are severely limited by swelling.
**PMMA — Poly(methyl methycrylate)
PBS — Poly(butene-1-sulfone)
FBM — Poly(fluoro butyl methacrylate)
PGMA-EA — Poly(glycidyl methacrylate ethylacrylate copolymer)

After U.V. exposure, E-beam exposure or X-ray exposure the polymer films are readily removed by washing with a DMF solution which contained a few drops of the reducing agent hydrazine. Because this works by reducing the oxidized films, it is likely that other reducing agents (and solvents) can similarly be used.

Other functionalized polymers, e.g., poly(epichlorohydrin), poly(halophosphazenes), poly(acrylic chloride) and copolymers of the same where reacted with donors listed above. The resultant electroactive polymers were treated as in Examples 1—5 above and provided good images when exposed to U.V. radiation, E-beam radiation or X-ray radiation.

## Claims

1. Photo-, E-beam, and X-ray sensitive negative resists comprising active polymers consisting of a polymer backbone and an active molecule bonded thereto, said molecule
a) being capable of electron oxidation to a cation;
b) having an oxidation potential of from about 0.1 V to about 1 V measured against a standard calomel electrode;
c) being capable of photoionizing in the presence of a halogen containing organic compound; and
d) having a functional group which when reacted with a polymer support will be bonded thereto;
and said active polymers being doped with a halogen containing organic compound.

2. Negative resist according to claim 1, characterized in that the polymer backbone is selected from the group consisting of polystyrene, a copolymer of styrene and chloromethylated styrene, polyglutamic acid, polyvinylchloride, polyvinylbenzylchloride, polyepichlorohydrin, poly($\alpha$ halo phosphazene) and poly (acrylic chloride).

3. Negative resist according to claim 1, characterized in that the active molecule is a donor molecule selected from the group consisting of tetrathiafulvalene and its derivatives, dithiadiselenafulvalene and its derivatives, tetrathiatetracene, amines having the formula R-$NH_2$ where R can be alkyl and/or aryl, pyrazolines, ferrocene and phenothiazine, said donor molecule being capable of forming a salt in the presence of actinic, E-beam or X-ray radiation with an acceptor selected from the group of halogen containing organic compounds.

4. Negative resist according to claim 1, characterized in that the halogen containing organic compound is selected from the group of $CCl_4$, $CBr_4$, $CI_4$, $C_2Cl_6$, $C_2Cl_2Br_4$, $C_3Br_4H_4$, $C_2Br_2Cl_4$, $C_2H_2Cl_4$, $C_2Br_6$, $C_3Cl_8$, $CHBr_3$, $CHCl_3$, and $CH_2Cl_2$.

5. Negative resist according to claims 1 and 3, characterized in that the donor molecule is attached to the polymer backbone via a functional group selected from hydroxyl, phenoxy, carboxyl or amino or that the active molecule is synthesized from polymer/precursors directly on the resin.

6. Negative resist according to claims 1, 2 and 3, characterized in that the polymer backbone is polyvinylbenzylchloride having a donor molecule selected form the group consisting of tetrathiafulvalene, dithiadiselenafulvalene, tetrathiatetracene, an amine having the formula R-$NH_2$ where R can be alkyl and/or aryl, N,N-dimethyl-p-phenylene diamine, pyrazoline, ferrocene and phenothiazine bonded thereto.

7. Negative resist according to claims 1, 2 and 3, characterized in that the polymer backbone is glutamic acid having a donor molecule selected from the group consisting of tetrathiafulvalene, dithiadiselenafulvalene, tetrathiatetracene, an amine having the formula R-$NH_2$ where R can be alkyl and/or aryl, N,N-dimethyl-p-phenylene diamine, pyrazoline, ferrocene and phenothiazine bonded thereto.

8. Negative resist according to claims 1, 2 and 3, characterized in that the polymer backbone is polyvinylchloride having a donor molecule selected from the group consisting of tetrathiafulvalene, dithiadiselenafulvalene, tetrathiatetracene, an amine having the formula R-$NH_2$ where R can be alkyl and/or aryl, N,N-dimethyl-p-phenylene diamine, pyrazoline, ferrocene and phenothiazine bonded thereto.

9. Negative resist according to claims 1, 2 and 3, characterized in that the polymer backbone is polyepichlorohydrin having a donor molecule selected from the group consisting of tetrathiafulvalene, dithiadiselenafulvalene, tetrathiatetracene, an amine having the formula R-$NH_2$ where R can be alkyl and/or aryl, N,N-dimethyl-p-phenylene diamine, pyrazoline, ferrocene and phenothiazine bonded thereto.

10. Negative resist according to claims 1, 2 and 3, characterized in that the polymer backbone is poly($\alpha$-halo-phosphazene) having a donor molecule selected from the group consisting of tetrathiafulvalene, dithiadiselenafulvalene, tetrathiatetracene, an amine having the formula R-$NH_2$ where R can be alkyl and/or aryl, N,N-dimethyl-p-phenylene diamine, pyrazoline, ferrocene and phenothiazine bonded thereto.

11. Negative resist according to claims 1, 2 and 3, characterized in that the polymer backbone is poly(acrylic chloride) having a donor molecule selected from the group consisting of tetrathiafulvalene, dithiadiselenafulvalene, tetrathiatetracene, an amine having the formula R-$NH_2$ where R can be alkyl and/or aryl, N,N-dimethyl-p-phenylene diamine, pyrazoline, ferrocene and phenothiazine bonded thereto.

12. Negative resist according to claims 1, 2 and 3, characterized in that the polymer backbone is polystyrene having a donor molecule selected from the groups consisting of tetrathiafulvalene, dithiadiselenafulvalene, tetrathiatetracene, an amine having the formula R-$NH_2$ where R can be alkyl and/or aryl, N,N-dimethyl-p-phenylene diamine, pyrazoline, ferrocene and phenothiazine bonded thereto.

13. A method for producing negative resist images using a negative resist according to claims 1 to 12, including the steps of
a) coating a film of a donor polymer-doped halocarbon charge transfer complex on a substrate,
b) exposing said film to U.V., E-beam or X-ray radiation and thereafter,
c) developing said exposed film in a suitable solvent.

**Revendications**

1. Matériaux résistifs négatifs, sensibles à la lumière, aux radiations électroniques et aux rayons X, comprenant: des polymères actifs consistant en un polymère tronc et en une molécule active qui lui est liée, ladite molécule

a) pouvant se transformer en cation par oxydation électronique,

b) ayant un potentiel d'oxydation compris entre environ 0,1 V à environ 1 V mesuré par rapport à une électrode de calomel,

c) pouvant se photo-ioniser en présence d'un composé organique halogéné; et

d) ayant un groupe fonctionnel qui, en réaction avec un support polymère, va lui est lié;

et lesdits polymères actifs étant dopés avec un composé organique halogéné.

2. Matériau résistif négatif selon la revendication 1, caractérisé en ce que le polymère tronc est sélectionné à partir du groupe polystyrène, copolymère de styrène et de styrène chlorométhylé, acide polyglutamique, chlorure de polyvinyle, chlorure de polyvinyle-benzyle, polyépichlorhydrine, poly ($\alpha$-halo phosphazène) et poly (chlorure acrylique).

3. Matériau résistif négatif selon la revendication 1, caractérisé en ce que la molécule active est une molécule donneuse sélectionnée dans le groupe tétrathiafulvalène et ses dérivés, dithiadisélénafulvalène et ses dérivés, tétrathiatétracène, amines de formule R-$NH_2$ où R peut être alkyl et/ou aryl, pyrazoline, ferrocène, et phénothiazine, ladite molécule donneuse pouvant former un sel en présence d'une radiation actinique, électronique ou de rayons X avec un accepteur sélectionné dans le groupe de composés organiques halogénés.

4. Matériau résistif négatif selon la revendication 1, caractérisé en ce que le composé organique halogéné est sélectionné dans le groupe de $CCl_4$, $CBr_4$, $Cl_4$, $C_2Cl_6$, $C_2Cl_2Br_4$, $C_3Br_4H_4$, $C_2Br_2Cl_4$, $C_2H_2Cl_4$, $C_2Br_6$, $C_3Cl_8$, $CHBr_3$ et $CH_2Cl_2$.

5. Matériaux résistif négatif selon les revendications 1 et 3, caractérisé en ce que la molécule donneuse est rattachée au polymère tronc par un groupe fonctionnel sélectionné dans le groupe hydroxyl, phénoxy, carboxyl ou amino ou en ce que la molécule active est synthétisée directement sur la résine à partir d'un mélange de polymère/précurseurs.

6. Matériau résistif négatif selon les revendications 1, 2 et 3, caractérisé en ce que le polymère tronc est du chlorure de polyvinyle-benzyle ayant une molécule donneuse sélectionnée dans le groupe tétrathiafulvalène, dithiadisélénafuvalène, tétrathiatétracène, amine de formule R-$NH_2$ où R peut être alkyl et/ou aryl, N,N-diméthyl-p-phénylène diamine, pyrazoline, ferrocène, et phénothiazine, qui lui sont liés.

7. Matériau résistif négatif selon les revendications 1, 2 et 3, caractérisé en ce que le polymère tronc est un acide glutamique ayant une molécule donneuse sélectionnée dans le groupe tétrathiafulvalène, dithiadisélénafuvalène, tétrathiatétracène, amine de formule R-$NH_2$ où R peut être alkyl et/ou aryl, N,N-diméthyl-p-phénylène diamine, pyrazoline, ferrocène, et phénothiazine, qui lui sont liés.

8. Matériau résistif négatif selon les revendications 1, 2 et 3, caractérisé en ce que le polymère tronc est du chlorure de polynyle ayant une molécule donneuse sélectionnée dans le groupe tétrathiafulvalène, dithiadisélénafuvalène, tétrathiatétracène, amine de formule R-$NH_2$ où R peut être alkyl et/ou aryl, N,N-diméthyl-p-phénylène diamine, pyrazoline, ferrocène, et phénothiazine, qui lui sont liés.

9. Matériau résistif négatif selon les revendications 1, 2 et 3, caractérisé en ce que le polymère tronc est du polyépichlorhydrine ayant une molécule donneuse sélectionnée dans le groupe tétrathiafulvalène, dithiadisélénafuvalène, tétrathiatétracène, amine de formule R-$NH_2$ où R peut être alkyl et/ou aryl, N,N-diméthyl-p-phénylène diamine, pyrazoline, ferrocène, et phénothiazine, qui lui sont liés.

10. Matériau résistif négatif selon les revendications 1, 2 et 3, caractérisé en ce que le polymère tronc est poly ($\alpha$-halo-phosphazène) ayant une molécule donneuse sélectionnée dans le groupe tétrathiafulvalène, dithiadisélénafuvalène, tétrathiatétracène, amine de formule R-$NH_2$ où R peut être alkyl et/ou aryl, N,N-diméthyl-p-phénylène diamine, pyrazoline, ferrocène, et phénothiazine, qui lui sont liés.

11. Matériau résistif négatif selon les revendications 1, 2 et 3, caractérisé en ce que le polymère tronc est poly (chlorure acrylique) ayant une molécule donneuse sélectionnée dans lr groupe tétrathiafulvalène, dithiadisélénafuvalène, tétrathiatétracène, amine de formule R—$NH_2$ où R peut être alkyl et/ou aryl, N,N-diméthyl-p-phénylène diamine, pyrazoline, ferrocène, et phénothiazine, qui lui sont liés.

12. Matériau résistif négatif selon les revendications 1, 2 et 3, caractérisé en ce que le polymère tronc est du polystyrène ayant une molécule donneuse sélectionnée dans le groupe tétrathiafulvalène, dithiadisélénafuvalène, tétrathiatétracène, amine de formule R-$NH_2$ où R peut être alkyl et/ou aryl, N,N-diméthyl-p-phénylène diamine, pyrazoline, ferrocène, et phénothiazine, qui lui sont liés.

13. Procédé pour la production d'images résistives négatives utillisant un matériau résistif négatif selon les revendications 1 à 12, comprenant les étapes de

a) revêtement d'un film comprenant un complexe de transfert de charges consistant en polymères donneurs dopés en halogénodydrocarbure, sur un substrat,

b) exposition dudit film à une radiation électronique, aux rayons X ou ultra-violets, et ensuite,
c) développement dudit film exposé dans un solvant approprié.

**Patentansprüche**

1. Photo-, elektronenstrahl- und röntgenstrahlempfindliche negative Resistmaterialien, bestehend aus aktiven Polymeren, welche aus einem Polymergerüst und einem an dieses gebundenen aktiven Molekül aufgebaut sind, wobei dieses Molekül
a) zur elektronischen Oxidation zu einem Kation befähigt ist;
b) ein Oxidationspotential von etwa 0,1 bis etwa 1 V aufweist, gemessen gegen eine Standard-Kalomelelektrode;
c) zur Photoionisation in Gegenwart einer halogenhaltigen organischen Verbindung befähig ist und
d) eine funktionelle Gruppe aufweist, welche, wenn sie mit einer Polymerunterlage umgesetzt wird, an diese gebunden wird;
und wobei die aktiven Polymeren mit einer halogenhaltigen organischen Verbindung dotiert sind.

2. Negativresistmaterial nach Anspruch 1, dadurch gekennzeichnet, daß das Polymergerüst ausgewählt ist aus der Gruppe von Polystyrol, einem Copolymer von Styrol und chlormethyliertem Styrol, Polyglutaminsäure, Polyvinylchlorid, Polyvinylbenzylchlorid, Polyepichlorhydrin, Poly($\alpha$-halophosphazen) und Polyacrylchlorid.

3. Negativresistmaterial nach Anspruch 1, dadurch gekennzeichnet, daß das aktive Molekül ein Donormolekül und ausgewählt ist aus der Gruppe von Tetrathiafulvalen und dessen Derivaten, Dithiadiselenafulvalen und dessen Derivaten, Tetrathiatetracen, Aminen der allgemeinen Formel R-$NH_2$, in der R Alkyl und/oder Aryl ist, Pyrazolin, Ferrocen und Phenothiazin, wobei das Donormolekül befähigt ist, in Gegenwart von aktinischer, Elektronen- oder Röntgenstrahlung mit einem Akzeptor aus der Gruppe halogenhaltiger organischer Verbindungen ein Salz zu bilden.

4. Negativresistmaterial nach Anspruch 1, dadurch gekennzeichnet, daß die halogenhaltige organische Verbindung gewählt ist aus der Gruppe von $CCl_4$, $CBr_4$, $Cl_4$, $C_2Cl_6$, $C_2Cl_2Br_4$, $C_3Br_4H_4$, $C_2Br_2Cl_4$, $C_2H_2Cl_4$, $C_2Br_6$, $C_3Cl_8$, $CHBr_3$, $CHCl_3$ und $CH_2Cl_2$.

5. Negativresistmaterial nach den Ansprüchen 1 und 3, dadurch gekennzeichnet, daß das Donormolekül an das Polymergerüst über eine funktionelle Gruppe ausgewählt von Hydroxyl, Phenoxy, Carboxyl oder Amino gebunden ist, oder daß das aktive Molekül von Polymervorläufern direkt auf dem Harz synthetisiert wird.

6. Negativresistmaterial nach den Ansprüchen 1, 2 und 3, dadurch gekennzeichnet, daß das Polymergerüst Polyvinylbenzylchlorid ist mit einem an dieses gebundenen Donormolekül gewählt aus der Gruppe von Tetrathiafulvalen, Dithiadiselenafulvalen, Tetrathiatetracen, einem Amin der allgemeinen Formel R-$NH_2$, in der R Alkyl und/oder Aryl ist, N,N-Dimethyl-p-phenylendiamin, Pyrazolin, Ferrocen und Phenothiazin.

7. Negativresistmaterial nach den Ansprüchen 1, 2 und 3, dadurch gekennzeichnet, daß das Polymergerüst Glutaminsäure ist mit einem an dieses gebundenen Donormolekül gewählt aus der Gruppe von Tetrathiafulvalen, Dithiadiselenafulvalen, Tetrathiatetracen, einem Amin mit der allgemeinen Formel R-$NH_2$, in der R Alkyl und/oder Aryl ist, N,N-Dimethyl-2-phenylendiamin, Pyrazolin, Ferrocen und Phenothiazin.

8. Negativresistmaterial nach den Ansprüchen 1, 2 und 3, dadurch gekennzeichnet, daß das Polymergerüst Polyvinylchlorid ist mit einem an dieses gebundenen Donormolekül gewählt aus der Gruppe von Tetrathiafulvalen, Dithiadiselenafulvalen, Tetrathiatetracen, einem Amin der allgemeinen Formel R-$NH_2$, in der R Alkyl und/oder Aryl ist, N,N-Dimethyl-p-phenylendiamin, Pyrazolin, Ferrocen und Phenothiazin.

9. Negativresistmaterial nach den Ansprüchen 1, 2 und 3, dadurch gekennzeichnet, daß das Polymergerüst Polyepichlorhydrin ist mit einem an dieses gebundenen Donormolekül gewählt aus der Gruppe von Tetrathiafulvalen, Dithiadiselenafulvalen, Tetrathiatetracen, einem Amin mit der allgemeinen Formel R-$NH_2$, in der R Alkyl und/oder Aryl ist, N,N-Dimethyl-p-phenylendiamin, Pyrazolin, Ferrocen und Phenothiazin.

10. Negativresistmaterial nach den Ansprüchen 1, 2 und 3, dadurch gekennzeichnet, daß das Polymergerüst Poly-($\alpha$-halo-phosphazen) ist mit einem an dieses gebundenen Donormolekül gewählt aus der Gruppe von Tetrathiafulvalen, Dithiadiselenafulvalen, Tetrathiatetracen, einem Amin mit der allgemeinen Formel R-$NH_2$, in der R Alkyl und/oder Aryl ist, N,N-Dimethyl-p-phenylendiamin, Pyrazolin, Ferrocen und Phenothiazin.

11. Negativresistmaterial nach den Ansprüchen 1, 2 und 3, dadurch gekennzeichnet, daß das Polymergerüst Polyacrylchlorid ist mit einem an dieses gebundenen Donormolekül gewählt aus der Gruppe von Tetrathiafulvalen, Dithiadiselenafulvalen, Tetrathiatetracen, einem Amin mit der allgemeinen Formel R-$NH_2$, in der R Alkyl und/oder Aryl ist, N,N-Dimethyl-p-phenylendiamin, Pyrazolin, Ferrocen und Phenothiazin.

12. Negativresistmaterial nach den Ansprüchen 1, 2 und 3, dadurch gekennzeichnet, daß das Polymergerüst Polystyrol ist mit einem an dieses gebundenen Donormolekül gewählt aus der Gruppe von Tetrathiafulvalen, Dithiadiselenafulvalen, Tetrathiatetracen, einem Amin mit der allgemeinen Formel

$R-NH_2$, in der R Alkyl und/oder Aryl ist, N,N-Dimethyl-p-phenylendiamin, Pyrazolin, Ferrocen und Phenothiazin.

13. Verfahren zur Herstellung negativer Resistbilder unter Verwendung eines negativen Resistmaterials nach den Ansprüchen 1 bis 12, gekennzeichnet durch folgende Verfahrensschritte.

a) Aufbringen eines Films aus einem mit einem Donormolekül dotierten Polymer, welches mit einer Halocarbonverbindung einen Ladungsübertragungskomplex bildet, auf eine Unterlage,

b) Belichten dieses Films mit UV-, Elektronen- oder Röntgenstrahlen und anschließend

c) Entwickeln des in dieser Weise belichteten Films mit einem geeigneten Lösungsmittel.

FIG. 1

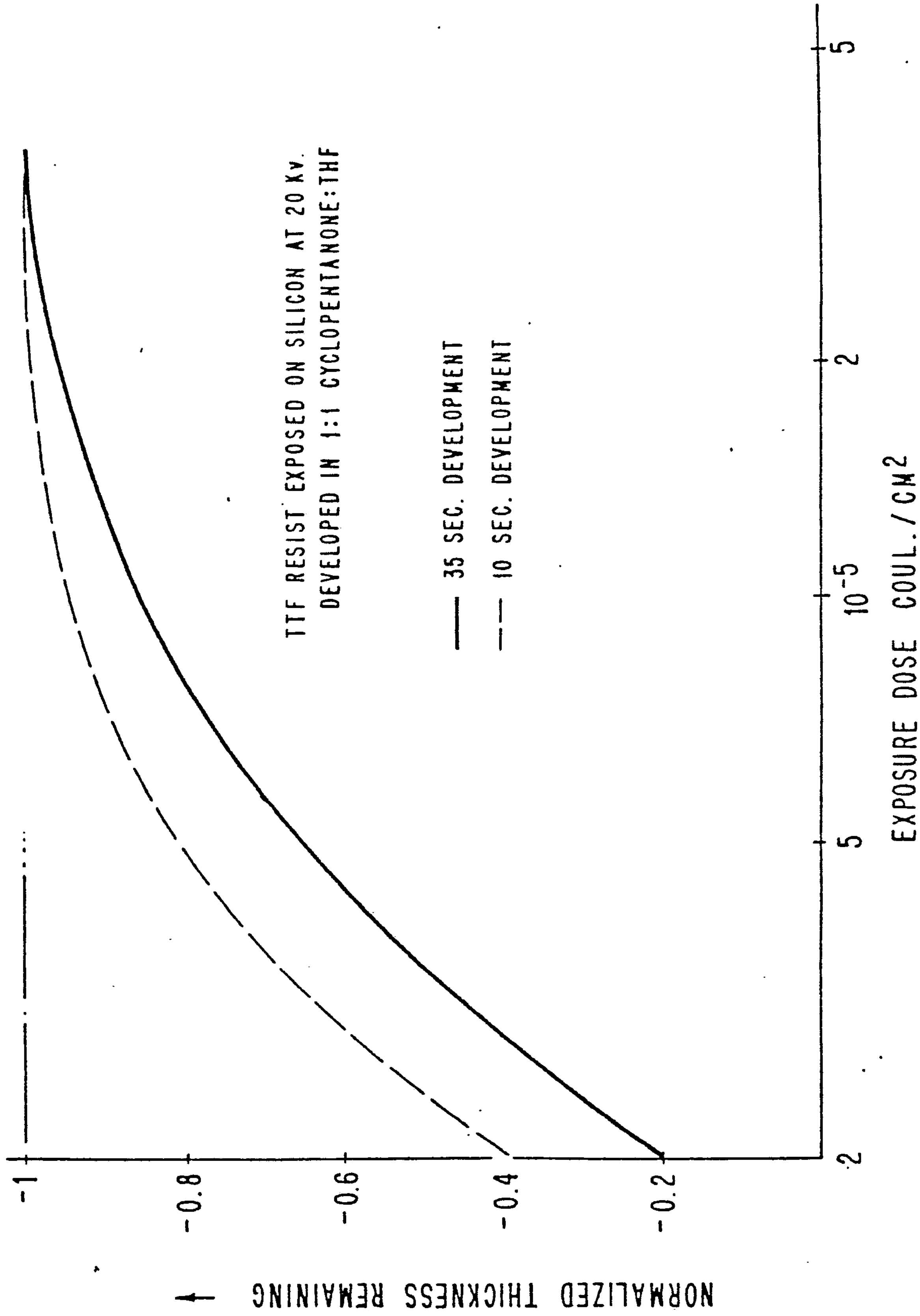
TTF RESIST EXPOSED ON SILICON AT 20 Kv.
DEVELOPED IN 1:1 CYCLOPENTANONE:THF
35 SEC. DEVELOPMENT
10 SEC. DEVELOPMENT
-1
-0.8
-0.6
-0.4
-0.2
2
5
$10^{-5}$
2
5
EXPOSURE DOSE COUL./CM$^2$
NORMALIZED THICKNESS REMAINING

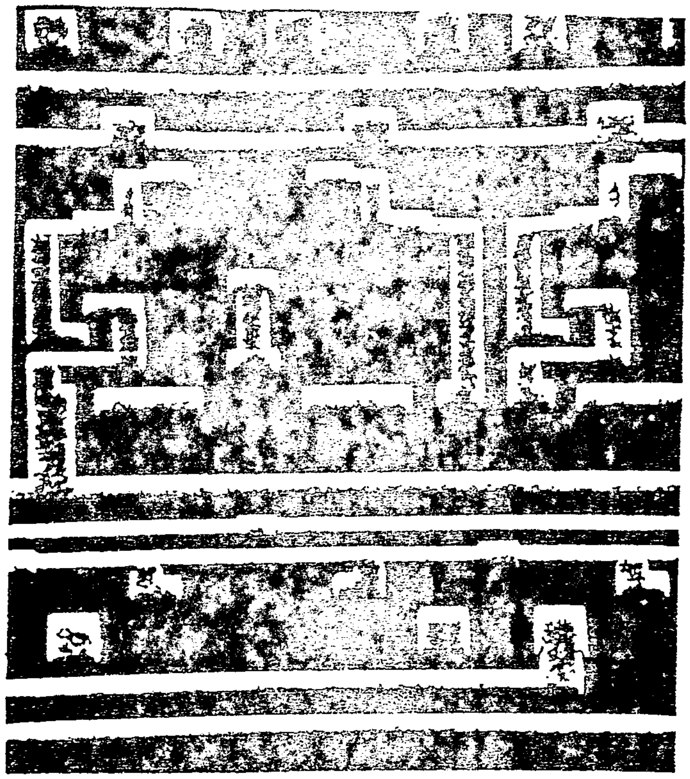

FIG. 2A

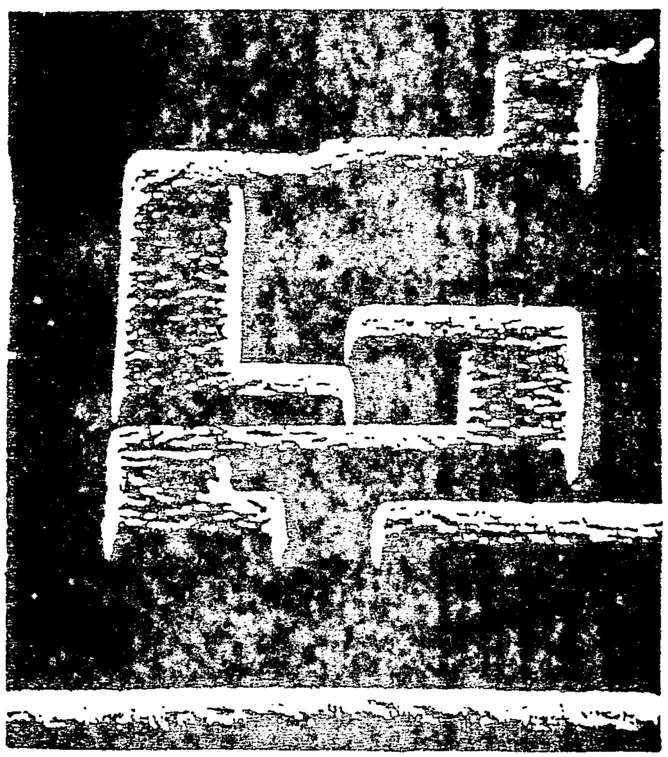

FIG. 2B

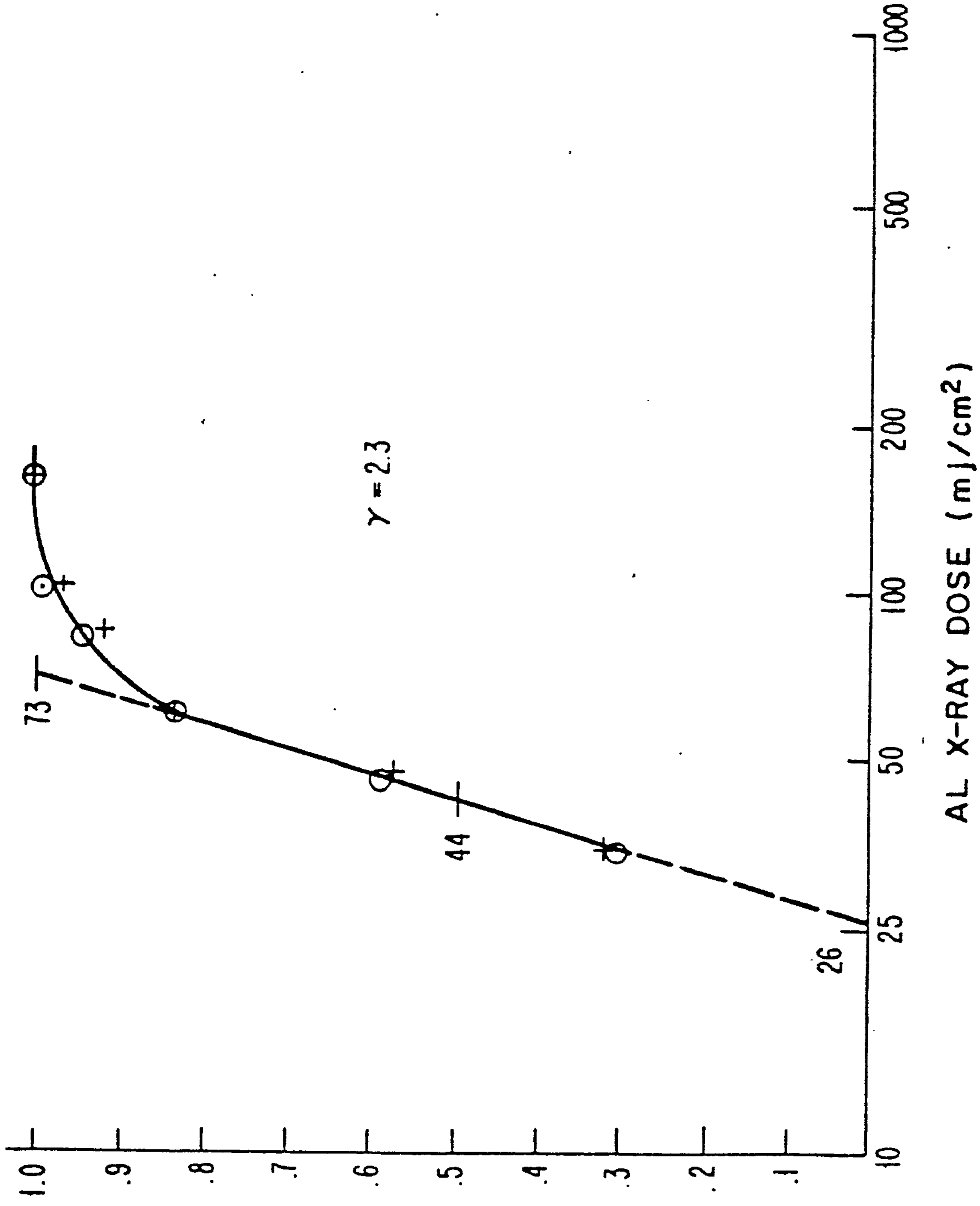


FIG. 3

THICKNESS REMAINING

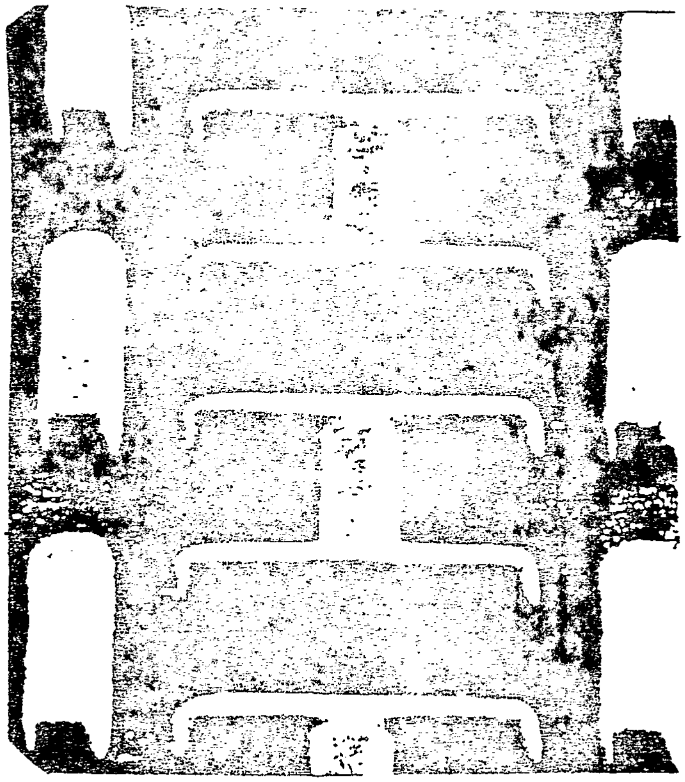

FIG. 4

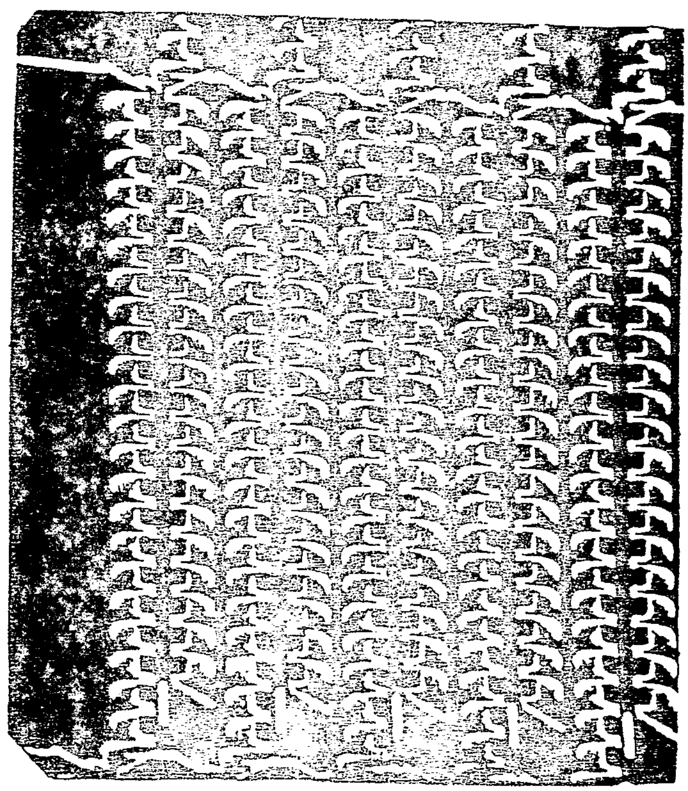

FIG. 5